# EUROPEAN PATENT APPLICATION

(11) **EP 4 681 970 A1**
(43) Date of publication of application: **21.01.2026**
(21) Application number: 24765932.9
(22) Date of filing: 05.07.2024
(51) Int. Cl.: B60L 8/00, B60K 16/00, B60L 50/60

(54) **VEHICLE HAVING PHOTOVOLTAIC CELLS AND MANUFACTURING METHOD THEREFOR**

(30) Priority: 31.05.2024 CN 202410699318
(71) Applicant: Trinaway Jiangsu Co., Ltd., Changzhou, Jiangsu 213031 (CN)
(72) Inventor: DIAO, Jinlong, Changzhou, Jiangsu 213031 (CN); HE, Wei, Changzhou, Jiangsu 213031 (CN); GAO, Xiaoyan, Changzhou, Jiangsu 213031 (CN); ZHOU, Haoying, Changzhou, Jiangsu 213031 (CN); HUANG, Bin, Changzhou, Jiangsu 213031 (CN); ZHU, Juehao, Changzhou, Jiangsu 213031 (CN); LIANG, Yungang, Changzhou, Jiangsu 213031 (CN)
(74) Representative: Arnold & Siedsma
(86) International application number: PCT/CN2024/103955
(87) International publication number: WO 2025/245962

(57) **Abstract**

The application relates to a vehicle having photovoltaic cells and a method for manufacturing the same. The vehicle having photovoltaic cells includes a first photovoltaic cell structure (100), a second photovoltaic cell structure (200), a third photovoltaic cell structure (300), a sunroof glass (420), a rear trunk lid (430), a hood (440), a vehicle door (450), a rear windshield (470), a front windshield (410) and a vehicle window (460). At least one of the first photovoltaic cell structure (100), the second photovoltaic cell structure (200), or the third photovoltaic cell structure (300) is arranged on each of the sunroof glass (420) and the rear trunk lid (430). The second photovoltaic cell structure (200) is arranged on each of the hood (440) and the vehicle door (450). At least one of the first photovoltaic cell structure (100) and the second photovoltaic cell structure (200) is arranged on the rear windshield (470). The first photovoltaic cell structure (100) is arranged at a position of a sunshade strip of the front windshield (410). The first photovoltaic cell structure (100), the second photovoltaic cell structure (200), and the third photovoltaic cell structure (300) are electrically connected to a vehicle-mounted battery.

## Description

### CROSS-REFERENCE TO RELATED APPLICATIONS

This application claims priority to Chinese Patent Application No. 2024106993187, filed on May 31, 2024, entitled "VEHICLE HAVING PHOTOVOLTAIC CELLS AND METHOD FOR MANUFACTURING THE SAME", the entire content of which is incorporated herein by reference in its entirety.

### TECHNICAL FIELD

The present application relates to the technical field of vehicles, in particular to a vehicle having photovoltaic cells and a method for manufacturing the same.

### BACKGROUND

Mobile photovoltaic systems are powered by solar energy, which can effectively solve electricity issues in areas where the electrical grid is difficult to extend, and can be applied to various mobile devices, such as vehicles, ships, satellites, etc., to provide portable power supply. Currently, photovoltaic products for mobile vehicles are widely used. The mainstream photovoltaic products for mobile vehicles involve arranging photovoltaic cells within laminated glass, arranging photovoltaic modules on roof racks, using foldable photovoltaic power generation devices, or attaching photovoltaic modules to hoods (i.e., bonnets) or trunk lids, so as to convert solar energy into electric energy to supply power to the vehicles. These methods can improve the vehicle's range to some extent.

Limited by the efficiency limit of photovoltaic cells, the actual power generated by the vehicle-mounted photovoltaic products currently on the market can only meet the power supply for a vehicle ventilation system or provide power for a vehicle-mounted rechargeable battery, which has little effect on the vehicle's actual range.

### SUMMARY

According to various embodiments of the present application, a vehicle having photovoltaic cells and a method for manufacturing the same are provided.

In a first aspect, the present application provides a vehicle having photovoltaic cells, which includes a first photovoltaic cell structure, a second photovoltaic cell structure, a third photovoltaic cell structure, a sunroof glass, a rear trunk lid, a hood, a vehicle door, a rear windshield, a front windshield, and a vehicle window;
at least one selected from the first photovoltaic cell structure, the second photovoltaic cell structure, and the third photovoltaic cell structure is arranged on each of the sunroof glass and the rear trunk lid;
the second photovoltaic cell structure is arranged on each of the hood and the vehicle door;
at least one selected from the first photovoltaic cell structure and the second photovoltaic cell structure is arranged on the rear windshield;
the first photovoltaic cell structure is arranged at a position of a sunshade strip of the front windshield; and
the first photovoltaic cell structure, the second photovoltaic cell structure, and the third photovoltaic cell structure are electrically connected to a vehicle-mounted battery.

In one of the embodiments, the vehicle window, the sunroof glass, the rear trunk lid, the front windshield, and the rear windshield each include an upper encapsulation layer and a lower encapsulation layer, and the first photovoltaic cell structure is arranged between the upper encapsulation layer and the lower encapsulation layer.

In one of the embodiments, the vehicle having photovoltaic cells includes adhesive film layers arranged between the upper encapsulation layer and the lower encapsulation layer, and the first photovoltaic cell structure being fixedly connected to the upper encapsulation layer and the lower encapsulation layer through the adhesive film layers.

In one of the embodiments, the first photovoltaic cell structure includes:
a first transparent substrate provided with a first conductive film;
a nano porous semiconductor film arranged on the transparent substrate;
a dye sensitizer adsorbed on a surface of the nano porous semiconductor film;
a second transparent substrate provided with a second conductive film and opposite to the first transparent substrate;
a counter electrode arranged on a side of the second transparent substrate facing the nano porous semiconductor film; and
an electrolyte filled between the first transparent substrate and the second transparent substrate.

In one of the embodiments, upper encapsulation layer is made of glass, and the lower encapsulation layer is made of glass or transparent engineering plastic.

In one of the embodiments, a periphery of the sunroof glass is provided with a black printing area, the black printing area is configured to be bonded to a metal bracket and a movement mechanism of a sunroof of the vehicle, and a welding strip of the first photovoltaic cell structure is arranged in the black printing area.

In one of the embodiments, the second photovoltaic cell structure includes:
a substrate;
a back electrode arranged on the substrate;
an absorption layer arranged on a side of the back electrode away from the substrate;
a transition layer arranged on a side of the absorption layer away from the back electrode;
a window layer arranged on a side of the transition layer away from the absorption layer; and
a finger electrode layer arranged on a side of the window layer away from the transition layer.

In one of the embodiments, at least one anti-aging film is arranged on a surface of the finger electrode layer.

In one of the embodiments, the hood of the vehicle is provided with a reserved through hole, and a leading wire of the second photovoltaic cell structure is connected to the vehicle-mounted battery through the reserved through hole.

In one of the embodiments, the vehicle having photovoltaic cells further includes:
a solar controller arranged in an engine compartment, wherein the leading wire is electrically connected to the solar controller;
the vehicle-mounted battery is electrically connected to the solar controller;
the solar controller is configured to convert a low voltage of a direct current into a high voltage of the direct current through an inverter and transports the direct current with the high voltage to the vehicle-mounted battery.

In one of the embodiments, the substrate layer is made of stainless steel, and the hood of the vehicle is made of aluminum alloy, galvanized steel plate, or carbon fiber composite material.

In one of the embodiments, a side of the substrate facing the hood of the vehicle is provided with an adhesive, and the substrate is adhered to the hood of the vehicle or the vehicle door.

In one of the embodiments, the third photovoltaic cell structure includes a transparent conductive layer, a photoelectric absorption and conversion layer, another transparent conductive layer, a metal finger electrode layer, and an insulating passivation layer that are arranged sequentially, and the third photovoltaic cell structure is arranged within a laminated glass of any one of the sunroof glass, the rear windshield, the front windshield, and the rear trunk lid.

In one of the embodiments, the layers in the third photovoltaic cell structure are deposited in the laminated glass by vapor deposition.

In a second aspect, the present application provides a method for manufacturing a vehicle having photovoltaic cells, which includes:
arranging first photovoltaic cell structures optionally on corresponding structures of a vehicle window, a front windshield, a sunroof glass, rear windshield, and a rear trunk lid;
arranging second photovoltaic cell structures optionally on corresponding structures of a hood of the vehicle, a vehicle door, a sunroof, the rear trunk lid, and the rear windshield;
arranging third photovoltaic cell structures on corresponding structures of the sunroof and the rear trunk lid;
mounting the front windshield, the sunroof glass, the rear trunk lid, the hood of the vehicle, the vehicle door, the vehicle window, and the rear windshield onto a main body of the vehicle; and
connecting the first photovoltaic cell structures, the second photovoltaic cell structures, and the third photovoltaic cell structures to a vehicle-mounted battery.

In one of the embodiments, arranging the first photovoltaic cell structures optionally on the corresponding structures of the vehicle window, the front windshield, the sunroof glass, rear windshield, and the rear trunk lid includes:
placing lower encapsulation layers;
laying first adhesive layers on the lower encapsulation layers;
laying the first photovoltaic cell structures on the first adhesive layers;
laying second adhesive layers on the first photovoltaic cell structures;
placing upper encapsulation layers on the second adhesive layers; and
laminating and encapsulation the lower encapsulation layers, the first adhesive layers, the first photovoltaic cell structures, the second adhesive layers, and the upper encapsulation layers to form the vehicle window, the front windshield, the sunroof glass, the rear windshield, and the rear trunk lid that having the first photovoltaic cell structures.

In one of the embodiments, arranging the second photovoltaic cell structures optionally on the corresponding structures of the hood of the vehicle, the vehicle door, the sunroof, the rear trunk lid, and the rear windshield includes:
cleaning surfaces of the second photovoltaic cell structures facing the hood of the vehicle, the vehicle door, the sunroof, the rear trunk lid or the rear windshield;
cleaning the hood of the vehicle, the vehicle door, the sunroof, the rear trunk lid, and the rear windshield;
pre-coating a surfactant on the cleaned surfaces of the hood of the vehicle, the vehicle door, the sunroof, the rear trunk lid, and the rear windshield;
arranging adhesives on the surfaces of the vehicle door, the sunroof, the rear trunk lid, and the rear windshield; and
adhering the second photovoltaic cell structures to the vehicle door, the sunroof, the rear trunk lid, and the rear windshield respectively.

In one of the embodiments, arranging the third photovoltaic cell structure on the corresponding structures of the sunroof and the rear trunk lid includes:
cleaning a surface of a tempered glass of the sunroof or the rear trunk lid; and
depositing a transparent conductive layer, a photoelectric absorption and conversion layer, another transparent conductive layer, a metal finger electrode layer, and an insulating passivation layer sequentially on the tempered glass.

Details of one or more embodiments of the present application are set forth in the following drawings and descriptions. Other features, objects and advantages of the present application will become apparent from the description, drawings, and claims.

### BRIEF DESCRIPTION OF THE DRAWINGS

To illustrate the technical solutions in the embodiments of the present application or in the prior art more clearly, the accompanying drawings for describing the embodiments or the prior art are introduced briefly in the following. Apparently, the accompanying drawings in the following description are only some embodiments of the present application, and persons of ordinary skill in the art can derive other drawings from the accompanying drawings without creative efforts.
FIG. 1 is a schematic structural view of a vehicle having photovoltaic cells according to an embodiment of the present application.
FIG. 2 is a schematic structural view of a third photovoltaic cell structure arranged on a vehicle window according to an embodiment of the present application.
FIG. 3 is a schematic structural view of a first photovoltaic cell structure arranged on a front windshield according to an embodiment of the present application.
FIG. 4 is a schematic structural view of a first photovoltaic cell structure arranged on a rear windshield according to an embodiment of the present application.
FIG. 5 is a schematic structural view of a first photovoltaic cell structure arranged on a vehicle window according to an embodiment of the present application.
FIG. 6 is a schematic flowchart of a method for manufacturing a vehicle having photovoltaic cells according to an embodiment of the present application.
FIG. 7 is a schematic flowchart of arranging first photovoltaic cell structures on corresponding structures of a front windshield, a sunroof glass, and a trunk lid in the method for manufacturing the vehicle having photovoltaic cells according to an embodiment of the present application.
FIG. 8 is a schematic flowchart of arranging second photovoltaic cell structures on corresponding structures of a vehicle hood and a vehicle door in the method for manufacturing the vehicle having photovoltaic cells according to an embodiment of the present application.
FIG. 9 is a schematic flowchart of arranging third photovoltaic cell structures on corresponding structures of a vehicle window and a rear windshield in the method for manufacturing the vehicle having photovoltaic cells according to an embodiment of the present application.

100 - First photovoltaic cell structure; 200 - Second photovoltaic cell structure; 300 - Third photovoltaic cell structure; 410 - Front windshield; 420 - Sunroof glass; 430 - Rear trunk lid; 440 - Hood; 450 - Vehicle door; 460 - Vehicle window; 470 - Rear windshield; 500 - Solar controller; 600 - Leading wire; 700 - Vehicle-mounted battery.

### DETAILED DESCRIPTION OF THE EMBODIMENTS

The technical solution in the embodiment of the present application will be clearly and completely described below in conjunction with the drawings in the embodiments of the application. Apparently, the described embodiments are only some rather than all of the embodiments of the application. Based on the embodiments in the present application, all other embodiments obtained by a person skilled in the art without creative efforts shall all fall within the protection scope of the present application.

In order to make the above objectives, features and advantages of the present application clear and easier to understand, the specific embodiments of the present application are described in detail below in combination with the accompanying drawings. Many specific details are set forth in the following description to facilitate a full understanding of the present application. However, the present application can be implemented in many ways different from those described herein, and those skilled in the art can make similar improvements without departing from the connotation of the present application. Therefore, the present application is not limited by the specific embodiments disclosed below.

In the description of the present application, it should be understood that the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential direction" are based on the azimuths or position relationships shown in the attached drawings. These terms are only for the convenience of describing the present application and simplifying the description, rather than indicating or implying that the indicated devices or elements must have the specific azimuths, or be constructed or operated in the specific azimuths, and therefore such terms cannot be understood as limitations of the present application.

In addition, the terms "first" and "second" are only used for descriptive purposes and cannot be understood as indicating or implying relative importance or implicitly indicating the number of indicated technical features. Thus, the features defined with "first" and "second" may explicitly or implicitly include at least one of the features. In the description of the present application, "a plurality of" means at least two, such as two, three, etc., unless otherwise expressly and specifically defined.

In the present application, unless otherwise expressly specified and limited, the terms "mount", "connect", "couple", "fix" and the like should be interpreted broadly. For example, the terms can mean fixed connection, detachable connection, or being integrated. The terms can mean mechanical connection or electrical connection. The terms can mean directly connection or indirectly connection through an intermediate medium. The terms can mean connection within two elements or interaction relationship between two elements, unless otherwise expressly limited. For those skilled in the art, the specific meaning of the above terms in the present application should be understood according to the specific situation.

In the present application, unless otherwise expressly specified and limited, a first feature "above" or "below" a second feature may be in direct contact with the second feature, or the first and second features may be in indirect contact through an intermediate medium. Moreover, the first feature "above" the second feature may be right above or obliquely above the second feature, or the first feature may be merely located at a height higher than the second feature. The first feature "below" the second feature may be right below or obliquely below the second feature, or the first feature may be merely located at a height lower than that of the second feature.

It should be noted that when an element is called "fixed to" or "mounted on" another element, it can be directly on another element or there can be an intermediate element. When an element is considered to be "connected" to another element, it can be directly connected to another element or there can be an intermediate element. The terms "vertical", "horizontal", "up", "down", "left", "right" and similar expressions used herein are for the purpose of illustration only and do not represent the only ways for implementation.

Details of one or more embodiments of the present application are set forth in the following drawings and descriptions.

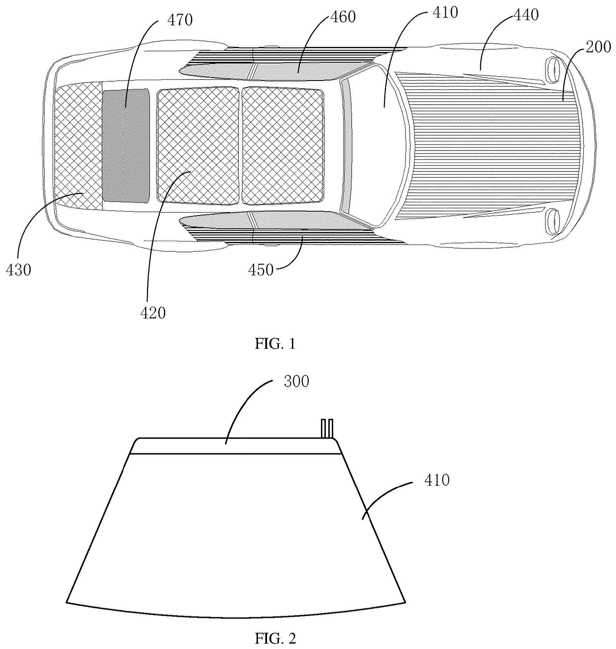

Referring to FIG. 1 to FIG. 5, an embodiment of the present application provides a vehicle having photovoltaic cells, and the vehicle having photovoltaic cells includes first photovoltaic cell structures, second photovoltaic cell structures, third photovoltaic cell structures, a sunroof glass 420, a rear trunk lid 430, a hood 440, a vehicle door 450, a rear windshield 470, a front windshield 410, and a vehicle window 460. At least one of a first photovoltaic cell structure 100, a second photovoltaic cell structure 200, or a third photovoltaic cell structure 300 is arranged on each of the sunroof glass 420 and the rear trunk lid 430. A second photovoltaic cell structure 200 is arranged on each of the hood 440 and the vehicle door 450. At least one of a first photovoltaic cell structure 400 or a second photovoltaic cell structure 200 is arranged on the rear windshield 470. A first photovoltaic cell structure 100 is arranged at a position of a sunshade strip of the front windshield 410. The first photovoltaic cell structures 100, the second photovoltaic cell structures 200, and the third photovoltaic cell structures 300 are electrically connected to a vehicle-mounted battery 700.

The present technical solution provides the vehicle having photovoltaic cells, in which at least one of a first photovoltaic cell structure 100, a second photovoltaic cell structure 200, or a third photovoltaic cell structure 300 is arranged on each of the sunroof glass 420 and the rear trunk lid 430, a second photovoltaic cell structure 200 is arranged on each of the hood 440 and the vehicle door 450, at least one of a first photovoltaic cell structure 100 or a second photovoltaic cell structure 200 is arranged on the rear windshield 470, and a first photovoltaic cell structure 100 is arranged at the position of the sunshade strip of the front windshield 410, so as to increase the area of the vehicle body covered with the photovoltaic cell structures. The first photovoltaic cell structures 100, the second photovoltaic cell structures 200, and the third photovoltaic cell structures 300 are electrically connected to the vehicle-mounted battery 700, so as to supply power to the vehicle-mounted battery 700 from the first photovoltaic cell structures 100, the second photovoltaic cell structures 200, and the third photovoltaic cell structures 300, thereby improving the vehicle's range. According to the present application, the area of the vehicle body can be fully utilized, so as to increase the arrangement area of the photovoltaic cells, and improve the overall power generation capacity of the vehicle.

In an embodiment, the vehicle window 460, the rear trunk lid 430, the rear windshield 470, the front windshield 410, and the sunroof glass 420 each include an upper encapsulation layer and a lower encapsulation layer, and each first photovoltaic cell structure 100 is arranged between the corresponding upper encapsulation layer and lower encapsulation layer. It should be understood that the upper encapsulation layer and the lower encapsulation layer of the front windshield 410 or the sunroof glass 420 should be made of a transparent material. In this way, on the one hand, the field of vision of the vehicle can be ensured, and on the other hand, solar energy can be provided for the normal operation of the first photovoltaic cell structure 100. Specifically, the upper encapsulation layer is made of glass, and the lower encapsulation layer is made of glass or a transparent engineering plastic. The upper encapsulation layer is typically made of semi-tempered glass to increase the structural strength of the entire front windshield 410 and sunroof glass 420. The lower encapsulation layer can be a transparent engineering plastic, for example, polyethylene terephthalate (PET), ethylene-tetrafluoroethylene copolymer (ETFE), polymethyl methacrylate (PMMA), polycarbonate (PC), etc. The lower encapsulation layer is preferably glass for structural strength and safety considerations.

It should be understood that the upper encapsulation layer and the lower encapsulation layer of each of the vehicle window 460, the rear trunk lid 430, the rear windshield 470, the front windshield 410, and the sunroof glass 420 can be used as encapsulation layers of the first photovoltaic cell structure 100 to encapsulate the first photovoltaic cell structure 100 into an interlayer space formed by the upper encapsulation layer and the lower encapsulation layer.

In an embodiment, adhesive film layers are arranged between the upper encapsulation layer and the lower encapsulation layer, and the first photovoltaic cell structure 100 is fixedly connected to the upper encapsulation layer and the lower encapsulation layer through the adhesive film layers. Specifically, the adhesive film layers are arranged on surfaces of the upper encapsulation layer and the lower encapsulation layer opposite to each other, and the adhesive film layers are made of a transparent material. In the present embodiment, the adhesive film layer can be made of polyvinyl butyral (PVB), ethylene-vinyl acetate copolymer (EVA), polyolefin elastomer, silicone, etc. The first photovoltaic cell structure 100 is arranged between the upper encapsulation layer and the lower encapsulation layer, and is fixedly connected to the upper encapsulation layer and the lower encapsulation layer by hot pressing, so that the vehicle window 460, the rear trunk lid 430, the rear windshield 470, the front windshield 410, or the sunroof glass 420 with the first photovoltaic cell structure 100 arranged therein can be formed. The vehicle window 460, the rear trunk lid 430, the rear windshield glass 470, the front windshield glass 410 and the sunroof glass 420 are mounted at corresponding positions of the vehicle, which not only have the functional characteristics of the vehicle window 460, the rear trunk lid 430, the rear windshield glass 470, the front windshield glass 410, and the sunroof glass 420 themselves, but also can effectively convert solar energy into electric energy to provide energy for the vehicle.

In an embodiment, the first photovoltaic cell structure 100 includes a first transparent substrate, a nano porous semiconductor film, a dye sensitizer, a second transparent substrate, and a counter electrode. The first transparent substrate is provided with a first conductive film. The nano porous semiconductor film is arranged on the transparent substrate. The dye sensitizer is adsorbed on a surface of the nano porous semiconductor film. The second transparent substrate is provided with a second conductive film and is opposite to the first transparent substrate. The counter electrode is arranged on a side of the second transparent substrate facing the nano porous semiconductor film. An electrolyte is filled between the first transparent substrate and the second transparent substrate.

Specifically, the first transparent substrate and the second transparent substrate can be made of glass. The first conductive film is disposed on the first transparent substrate, and the second conductive film is disposed on the second transparent substrate, so that both the first transparent substrate and the second transparent substrate are electrically conductive. It should be understood that the first transparent substrate having the first conductive film and the second transparent substrate having the second conductive film each can be formed by forming a conductive film on a glass. A light transmittance of the first transparent substrate and the second transparent substrate is greater than 85%. The first conductive film and the second conductive film are configured to collect and transport electrons.

The nano porous semiconductor film is specifically a nano titanium dioxide porous film. The nano porous semiconductor film is a carrier of the dye sensitizer, and the nano porous semiconductor film is also a medium for electron acquisition and electron conduction. The dye sensitizer is a key factor to absorb light energy. The counter electrode is configured to catalyze the reaction between electrons in the electrolyte, so that the whole photoelectric chemical reaction can be cycled. The electrolyte mainly plays a role in transporting particles and regenerating dyes. The electrolyte can be a liquid, a solid, or a quasi-solid.

The first photovoltaic cell structure 100 with the above structure can convert solar energy into electric energy through the photoelectric effect to provide energy for the vehicle. The first photovoltaic cell structure 100 is semi-transparent, and can block a part of sunlight from passing through the front windshield 410 or the sunroof glass 420, thereby reducing the interference of direct sunlight on the driving of personnel in the vehicle.

As shown in FIG. 2, the first photovoltaic cell structure 100 is arranged on a top portion of the front windshield 410, and the other areas of the front windshield 410 are transparent to provide a necessary view for the driver.

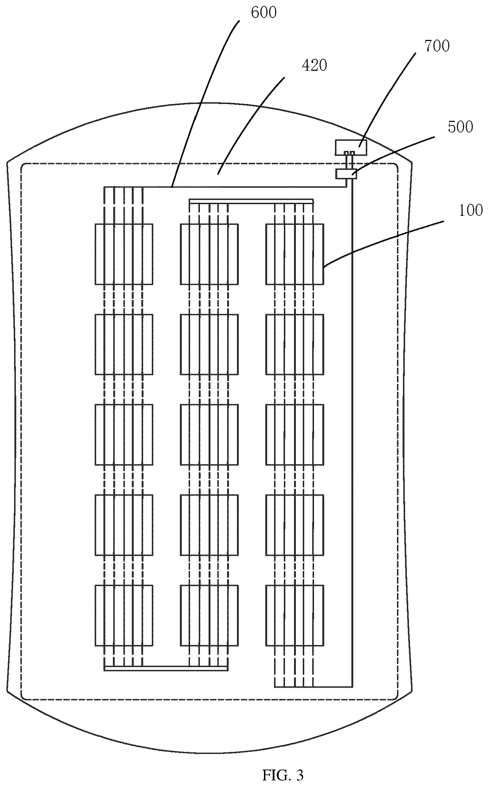

As shown in FIG. 3, in an embodiment, a periphery of the sunroof glass 420 is provided with a black printing area, and the black printing area of the sunroof glass 420 is configured to be bonded to a metal bracket and a movement mechanism of a sunroof of the vehicle. A welding strip of the first photovoltaic cell structure 100 is arranged in the black printing area.

In this embodiment, the sunroof glass 420 is mounted in a roof mounting frame of the vehicle. The periphery of the sunroof glass 420 is provided with a circular black printing area configured to be bonded to the metal bracket and the movement mechanism of the sunroof of the vehicle. The first photovoltaic cell structure 100 is disposed in the sunroof glass 420. The sunroof glass 420 includes the transparent upper encapsulation layer and the lower encapsulation layer. The upper encapsulation layer is generally made of tempered glass to increase the structural strength and the lower encapsulation layer can be made of glass or a transparent engineering plastic, such as PET, ETFE, PMMA, PC, etc. The transparent adhesive film layers are arranged between the upper encapsulating layer and the lower encapsulating layer. The transparent adhesive film layer is typically a PVB film, an EVA film, a polyolefin elastomer, an organic silicon film, etc. The first photovoltaic cell structure 100 is located between the adhesive film layers. Under the condition that the mechanical strength of the lower encapsulation layer is sufficient to support the movement mechanism of the sunroof, the black printing area is arranged on a surface (inner surface) of the lower encapsulation layer facing an interior of the vehicle, and is configured to be bonded to the metal bracket and the movement mechanism of the sunroof and hide a connection welding strip of a first photovoltaic cell structure unit, so that a continuous and consistent black printing area is formed. As the largest transparent area of the vehicle, the sunroof at the top portion of the vehicle is arranged with opaque solar cells, which is more efficient and maximizes the power generation.

In addition, the first photovoltaic cell structure 100 is also disposed on the rear trunk lid 430. A laminated glass on the rear trunk lid 430 is consistent with the above-mentioned sunroof glass 420 and the front windshield 410, and may serve as an upper encapsulation layer and a lower encapsulation layer, and the first photovoltaic cell structure 100 is disposed in the laminated glass.

In the first photovoltaic cell structure 100, the first transparent substrate and the second transparent substrate are ultra-thin glasses each with a thickness ranged from 200 µm to 700 µm, or transparent polymer films each with a thickness ranged from 50 µm to 300 µm. A transmittance of the substrate for visible and near-infrared lights with a wavelength from 380 nm to 1100 nm is greater than or equal to 80%. A transparent conductive film, a photoelectric absorption and conversion layer, a transparent conductive film, and an insulating passivation protective layer are arranged in sequence on the substrate.

In an embodiment, the second photovoltaic cell structure 200 includes a substrate, a back electrode, a transition layer, a window layer, and a finger electrode layer. The back electrode is arranged on the substrate. An absorption layer is arranged on a side of the back electrode away from the substrate. The transition layer is arranged on a side of the absorption layer away from the back electrode. The window layer is arranged on a side of the transition layer away from the absorption layer. The finger electrode layer is arranged on a side of the window layer away from the transition layer.

The second photovoltaic cell structure 200 provided in this embodiment is a film solar cell, wherein the substrate is a stainless-steel substrate, the back electrode is made of molybdenum metal, the absorption layer is a copper indium gallium selenide light absorption layer, the transition layer is a cadmium sulfide transition layer, and the window layer is made of zinc oxide. The film solar cell has stable performance, strong radiation resistance, low cost and high photoelectric conversion efficiency.

Specifically, a molybdenum electrode can be manufactured on a stainless-steel substrate by magnetron sputtering. A copper-indium-gallium pre-layer is formed by sputtering metal elements of copper, indium and gallium on the stainless-steel substrate with the molybdenum electrode, and then is formed into the copper-indium-gallium-selenium light absorption layer through two stages of selenization which are low-temperature selenization and high-temperature selenization in a mixed gas environment of hydrogen and argon. A cadmium sulfide transition layer is manufactured by chemical bath deposition. A zinc oxide layer doped with zinc oxide and aluminum is manufactured by sputtering, and finally a nickel-aluminum finger electrode is evaporation deposited. In this way, the first photovoltaic cell structure 100 is formed.

In an embodiment, at least one anti-aging film is arranged on a surface of the finger electrode layer. Specifically, the anti-aging film is a polymer film with a certain transparency, and can be a polyethylene terephthalate (PET), polyvinylidene fluoride (PVDF) or polyvinyl fluoride (PVF) film. A thickness of the anti-aging film is smaller than or equal to 50 µm.

Specifically, the hood 400 of the vehicle is provided with a reserved through hole, and a leading wire 600 of the second photovoltaic cell structure 200 is connected to the vehicle-mounted battery 700 through the reserved through hole. By arranging the reserved through hole on the hood 400 of the vehicle, the leading wire 600 of the second photovoltaic cell structure 200 can extend through the reserved through hole, so as to be connected to the vehicle-mounted battery 700. In this way, the electric energy generated by the second photovoltaic cell structure 200 is transported to the vehicle-mounted battery 700 for powering the vehicle. Further, the vehicle having photovoltaic cells further includes a solar controller 500 arranged in an engine compartment. The leading wire 600 is electrically connected to the solar controller 500, and the vehicle-mounted battery 700 is electrically connected to the solar controller 500. The solar controller 500 converts a low voltage of a direct current into a high voltage of a direct current through an inverter and transports the direct current with the high voltage to the vehicle-mounted battery 700.

In an embodiment, the substrate layer is made of stainless steel. The hood 440 of the vehicle is made of aluminum alloy, galvanized steel sheet, or carbon fiber composite material. When the substrate layer is made of stainless steel, the heat generated by the operation of the engine and transferred to the bottom portion of the cell through the hood 440 of the vehicle can be dissipated as the stainless-steel substrate has a large thermal conductivity, thereby stabilizing the power generation efficiency of the cell and protecting the service life of the cell. On the other hand, since the hood is also made of alloy such as a galvanized steel plate, etc., the difference between the thermal expansion coefficients of the hood and the stainless-steel substrate of the cell is relatively small, which can improve the deformation of the cell unit caused by a difference in thermal expansion and contraction between the solar cell and the hood.

In an embodiment, a side of the substrate facing the hood 440 is provided with an adhesive, and the substrate is adhered to the hood 440 of the vehicle or the vehicle door 450. The adhesive attached to the stainless-steel substrate is configured to adhere the stainless-steel substrate of the second photovoltaic cell structure 200 to a surface of the hood. The adhesive can be epoxy resin, glass adhesive, silicone adhesive or polyurethane adhesive. The hood is made of aluminum alloy, galvanized steel plate or carbon fiber composite material.

Certainly, the second photovoltaic cell structure 200 can be any one of a PERC cell, an N-TopCon cell, a HIT cell, a HJT cell, or an IBC cell, and a thickness of the second photovoltaic cell structure 200 can be approximately between 50 µm to 200 µm. A length and a width of the second photovoltaic cell structure 200 can be one of one-sixth, one-fifth, one-quarter, one-half, or a multiple of 158 mm, 166 mm, 182 mm, or 210 mm. In a case of the second photovoltaic cell structure 200 being a copper-indium-gallium-selenium cell, the thickness thereof is between 100 µm to 200 µm.

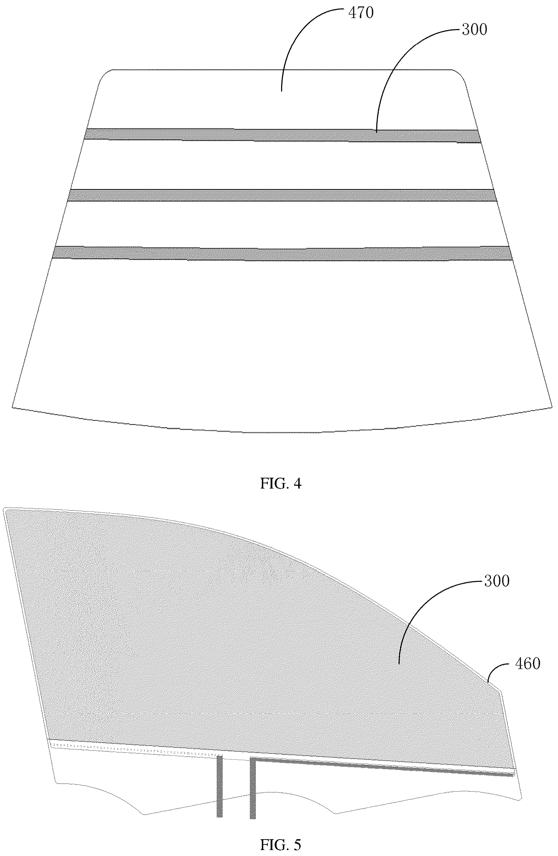

In an embodiment, the third photovoltaic cell structure 300 includes a transparent conductive layer, a photoelectric absorption and conversion layer, another transparent conductive layer, a metal finger electrode layer, and an insulating passivation layer that are arranged sequentially. As shown in FIG. 5, the third photovoltaic cell structure 300 is arranged within a laminated glass of the vehicle window 460 or the rear windshield 470. The layers in the third photovoltaic cell structure 300 are deposited on a glass of the vehicle window 460 or the rear windshield 470 by vapor deposition.

The third photovoltaic cell structure 300 is mounted on each of the sunroof and the rear trunk lid. The transparent conductive layer, the photoelectric absorption and conversion layer, the other transparent conductive layer, the metal finger electrode layer, and the insulating passivation layer are sequentially deposited on a semi-tempered glass of the sunroof and the rear trunk lid through coating, vapor deposition, etc. The semitransparent film solar cells located on the front and rear vehicle windows 460 have high transparency, and have certain radiation resistance and heat resistance due to the encapsulation film structure of the cell itself and the light absorption property of the material, and can replace a solar film on the glass of the sunroof and the rear trunk lid 460.

As shown in FIG. 4, specifically, the third photovoltaic cell structure 300 is arranged on the sunroof and the rear trunk lid. The transparent conductive layer, the photoelectric absorption and conversion layer, the other transparent conductive layer, and the insulating passivation protective layer are sequentially deposited on inner sides of the tempered glasses of the sunroof and the rear trunk lid. The transparent conductive layer, the photoelectric absorption and conversion layer, the other transparent conductive layer, and the insulating passivation protective layer are divided into strip-shaped power generation units disposed at intervals by using a laser film removal technology. The conductive film layer on an edge is reserved to keep the loop closed. When the sunshine is sufficient, the transparent film solar cell on the rear windshield can be used to generate electricity. In rainy and snowy weathers, a certain input voltage is input by controlling a switch, the cell unit is short-circuited, the semitransparent film solar cell is used as an electric load, and an indium tin oxide circuit in the cell can be heated to more than 40°C after being powered for a short time, so that the rear vehicle window is defrosted and defogged. The cell arrangement has the following advantages: firstly, the area of the vehicle can be fully utilized to improve the power generation, and secondly, can be used as heating wires on the rear windshield to defrost and defog the vehicle glass.

In the third photovoltaic cell structure 300, the visible light transmittance of the transparent conductive layer is greater than 85%, and the transparent conductive layer is made of indium tin oxide (ITO), aluminum-doped zinc oxide (AZO), boron-doped zinc oxide (BZO), gallium-doped zinc oxide (GZO), fluorine-doped tin oxide (FTO), conductive graphene, or nano silver. The photoelectric absorption and conversion layer is an amorphous silicon film, a microcrystalline silicon film, a copper-indium-gallium-tin film, a cadmium telluride film, a dye-sensitized material, or an organic polymer film. The visible light transmittance of the semitransparent film solar cell is ranged from 5% to 60%. The insulating passivation layer is a silicon dioxide film, a silicon nitride film, or polydimethylsiloxane, having a transmittance greater than or equal to 80% for visible light and near-infrared light with a wavelength from 380nm to 1100nm.

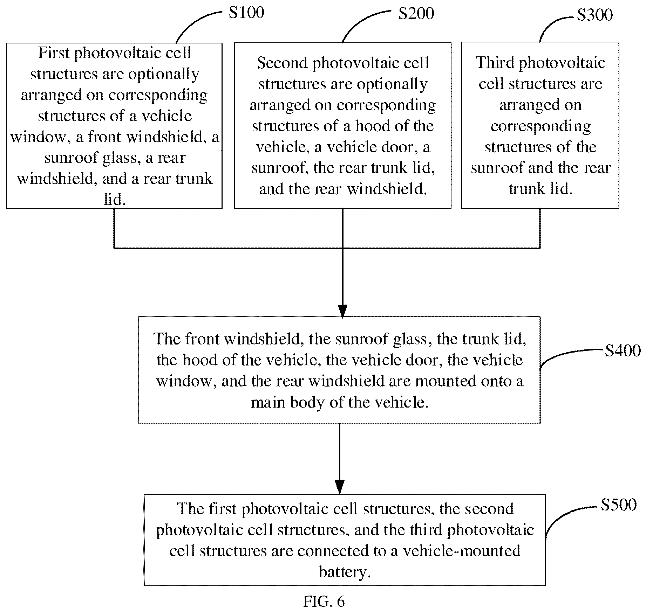

As shown in FIG. 6, an embodiment of the present application further provides a method for manufacturing a vehicle having photovoltaic cells, and the method for manufacturing the vehicle having photovoltaic cells are as follows:

S100, first photovoltaic cell structures are optionally arranged on corresponding structures of a vehicle window, a front windshield, a sunroof glass, a rear windshield, and a rear trunk lid.

S200, second photovoltaic cell structures are optionally arranged on corresponding structures of a hood of the vehicle, a vehicle door, a sunroof, the rear trunk lid, and the rear windshield.

S300, third photovoltaic cell structures are arranged on corresponding structures of the sunroof and the rear trunk lid.

S400, the front windshield, the sunroof glass, the trunk lid, the hood of the vehicle, the vehicle door, the vehicle window, and the rear windshield are mounted onto a main body of the vehicle.

S500, the first photovoltaic cell structures, the second photovoltaic cell structures, and the third photovoltaic cell structures are connected to a vehicle-mounted battery.

In this embodiment, through the above method, at least one photovoltaic cell structure selected from the first photovoltaic cell structures, the second photovoltaic cell structures and the third photovoltaic cell structures is arranged on each of the sunroof glass and the rear trunk lid; a second photovoltaic cell structure is arranged on each of the hood and the vehicle door; at least one photovoltaic cell structure selected from the first photovoltaic cell structures and the second photovoltaic cell structures is arranged on the rear windshield; and a first photovoltaic cell structure is arranged at a position of a sunshade strip of the front windshield. The first photovoltaic cell structure, the second photovoltaic cell structure and the third photovoltaic cell structure are electrically connected to the vehicle-mounted battery in the vehicle, so as to supply power to the vehicle-mounted battery, thereby improving the vehicle's range. Through the above method, the area of the vehicle body can be fully utilized, so as to increase the arrangement area of the photovoltaic cells, and improve the overall power generation capacity of the vehicle.

It should be noted that the order of steps S100, S200, and S300 is not limited, and the three steps may be performed simultaneously or sequentially. For example, in different production lines, at least one of a first photovoltaic cell structure, a second photovoltaic cell structure, or a third photovoltaic cell structure can be formed on each of the sunroof glass and the rear trunk lid, a second photovoltaic cell structure can be formed on each of the hood and the vehicle door, at least one of a first photovoltaic cell structure or a second photovoltaic cell structure can be formed on the rear windshield, and a first photovoltaic cell structure can be formed at the position of the sunshade strip of the front windshield.

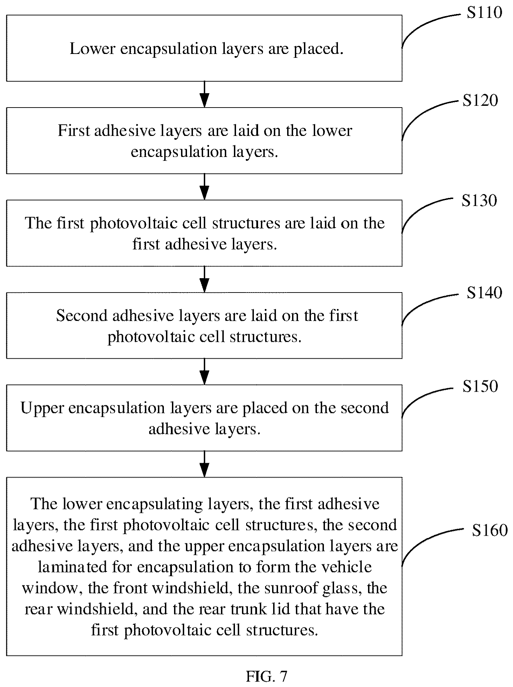

As shown in FIG. 7, in an embodiment, the arrangement of the first photovoltaic cell structures on corresponding structures of the front windshield, the sunroof glass, and the trunk lid are as follows:

S110, lower encapsulation layers are placed.

S120, first adhesive layers are laid on the lower encapsulation layers.

S130, the first photovoltaic cell structures are laid on the first adhesive layers.

S140, second adhesive layers are laid on the first photovoltaic cell structures.

S150, upper encapsulation layers are placed on the second adhesive layers.

S160, the lower encapsulating layers, the first adhesive layers, the first photovoltaic cell structures, the second adhesive layers, and the upper encapsulation layers are laminated for encapsulation to form the vehicle window, the front windshield, the sunroof glass, the rear windshield, and the rear trunk lid that have the first photovoltaic cell structures.

The lower encapsulation layer, the first adhesive layer, the first photovoltaic cell structure, the second adhesive layer, and the upper encapsulating layer are laid sequentially, and then the layers are encapsulated together by hot pressing. This process is simple and easy for operation. The first adhesive layer and the second adhesive layer are configured to adhere the first photovoltaic cell structure to the lower encapsulation layer and the upper encapsulation layer.

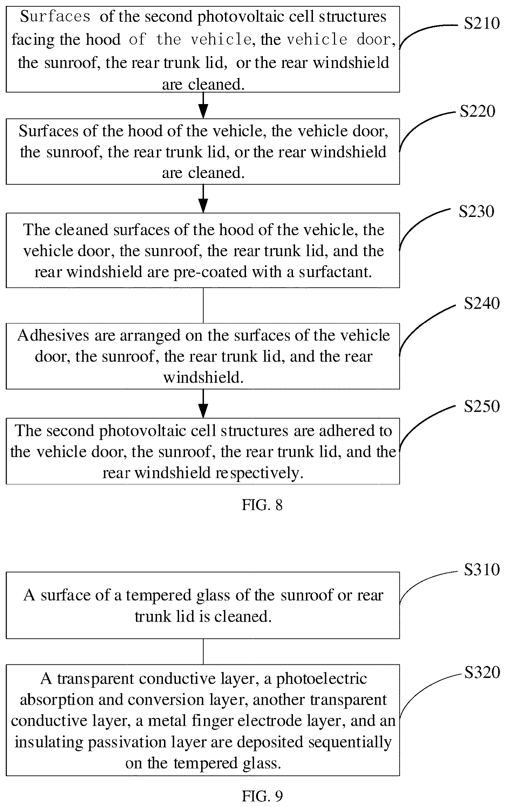

As shown in FIG. 8, in an embodiment, the arrangement of the first photovoltaic cell structures optionally on the corresponding structures of the vehicle window, the front windshield, the sunroof glass, the rear windshield, and the rear trunk lid are as follows:

S210, surfaces of the second photovoltaic cell structures facing the hood of the vehicle, the vehicle door, the sunroof, the rear trunk lid, or the rear windshield are cleaned.

S220, surfaces of the hood of the vehicle, the vehicle door, the sunroof, the rear trunk lid, or the rear windshield are cleaned.

S230, the cleaned surfaces of the hood of the vehicle, the vehicle door, the sunroof, the rear trunk lid, and the rear windshield are pre-coated with a surfactant.

S240, adhesives are arranged on the surfaces of the vehicle door, the sunroof, the rear trunk lid, and the rear windshield.

S250, the second photovoltaic cell structures are adhered to the vehicle door, the sunroof, the rear trunk lid, and the rear windshield respectively.

In this embodiment, the surfaces of the vehicle door, the sunroof, the rear trunk lid and the rear windshield that are to be adhered to the second photovoltaic cell structures are cleaned, and the surfaces of the second photovoltaic cell structures are cleaned, so as to improve the bonding strength between the second photovoltaic cell structures and the vehicle door, the sunroof, the rear trunk lid, and the rear windshield, thereby improving the service life of the second photovoltaic cell structures.

As shown in FIG. 9, in an embodiment, the arrangement of the third photovoltaic cell structures on the corresponding structures of the sunroof and the rear trunk lid are as follows:

S310, a surface of a tempered glass of the sunroof or rear trunk lid is cleaned.

S320, a transparent conductive layer, a photoelectric absorption and conversion layer, another transparent conductive layer, a metal finger electrode layer, and an insulating passivation layer are deposited sequentially on the tempered glass.

In this embodiment, the surface of the tempered glass of the vehicle window or the rear windshield is cleaned, so that the bonding strength between the tempered glass and the transparent conductive layer, the photoelectric absorption and conversion layer, the other transparent conductive layer, the metal finger electrode layer, and the insulating passivation layer that are deposited on the tempered glass is enhanced.

The foregoing descriptions are merely specific embodiments of the present application, but are not intended to limit the protection scope of the present application. Any variation or replacement readily achieved by a person skilled in the art without departing from the technical concept of the present application shall all fall within the protection scope of the present application.

## Claims

1. A vehicle having photovoltaic cells, **characterized by** comprising a first photovoltaic cell structure, a second photovoltaic cell structure, a third photovoltaic cell structure, a sunroof glass, a rear trunk lid, a hood, a vehicle door, a rear windshield, a front windshield, and a vehicle window;
at least one selected from the first photovoltaic cell structure, the second photovoltaic cell structure, and the third photovoltaic cell structure is arranged on each of the sunroof glass and the rear trunk lid;
the second photovoltaic cell structure is arranged on each of the hood and the vehicle door;
at least one selected from the first photovoltaic cell structure and the second photovoltaic cell structure is arranged on the rear windshield;
the first photovoltaic cell structure is arranged at a position of a sunshade strip of the front windshield; and
the first photovoltaic cell structure, the second photovoltaic cell structure, and the third photovoltaic cell structure are electrically connected to a vehicle-mounted battery.

2. The vehicle having photovoltaic cells according to claim 1, wherein the vehicle window, the sunroof glass, the rear trunk lid, the front windshield, and the rear windshield each comprise an upper encapsulation layer and a lower encapsulation layer, and the first photovoltaic cell structure is arranged between the upper encapsulation layer and the lower encapsulation layer.

3. The vehicle having photovoltaic cells according to claim 2, comprising adhesive film layers arranged between the upper encapsulation layer and the lower encapsulation layer, and the first photovoltaic cell structure being fixedly connected to the upper encapsulation layer and the lower encapsulation layer through the adhesive film layers.

4. The vehicle having photovoltaic cells according to claim 3, wherein the first photovoltaic cell structure comprises:
a first transparent substrate provided with a first conductive film;
a nano porous semiconductor film arranged on the transparent substrate;
a dye sensitizer adsorbed on a surface of the nano porous semiconductor film;
a second transparent substrate provided with a second conductive film and opposite to the first transparent substrate;
a counter electrode arranged on a side of the second transparent substrate facing the nano porous semiconductor film; and
an electrolyte filled between the first transparent substrate and the second transparent substrate.

5. The vehicle having photovoltaic cells according to claim 2, wherein the upper encapsulation layer is made of glass, and the lower encapsulation layer is made of glass or transparent engineering plastic.

6. The vehicle having photovoltaic cells according to claim 2, wherein a periphery of the sunroof glass is provided with a black printing area, the black printing area is configured to be bonded to a metal bracket and a movement mechanism of a sunroof of the vehicle, and a welding strip of the first photovoltaic cell structure is arranged in the black printing area.

7. The vehicle having photovoltaic cells according to any one of claims 1 to 6, wherein the second photovoltaic cell structure comprises:
a substrate;
a back electrode arranged on the substrate;
an absorption layer arranged on a side of the back electrode away from the substrate;
a transition layer arranged on a side of the absorption layer away from the back electrode;
a window layer arranged on a side of the transition layer away from the absorption layer; and
a finger electrode layer arranged on a side of the window layer away from the transition layer.

8. The vehicle having photovoltaic cells according to claim 7, wherein at least one anti-aging film is arranged on a surface of the finger electrode layer.

9. The vehicle having photovoltaic cells according to claim 7, wherein the hood of the vehicle is provided with a reserved through hole, and a leading wire of the second photovoltaic cell structure is connected to the vehicle-mounted battery through the reserved through hole.

10. The vehicle having photovoltaic cells according to claim 9, further comprising:
a solar controller arranged in an engine compartment, wherein the leading wire is electrically connected to the solar controller;
the vehicle-mounted battery is electrically connected to the solar controller;
the solar controller is configured to convert a low voltage of a direct current into a high voltage of the direct current through an inverter and transports the direct current with the high voltage to the vehicle-mounted battery.

11. The vehicle having photovoltaic cells according to claim 7, wherein the substrate layer is made of stainless steel, and the hood of the vehicle is made of aluminum alloy, galvanized steel plate, or carbon fiber composite material.

12. The vehicle having photovoltaic cells according to claim 7, wherein a side of the substrate facing the hood of the vehicle is provided with an adhesive, and the substrate is adhered to the hood of the vehicle or the vehicle door.

13. The vehicle having photovoltaic cells according to any one of claims 1 to 6, wherein the third photovoltaic cell structure comprises a transparent conductive layer, a photoelectric absorption and conversion layer, another transparent conductive layer, a metal finger electrode layer, and an insulating passivation layer that are arranged sequentially, and the third photovoltaic cell structure is arranged within a laminated glass of any one of the sunroof glass, the rear windshield, the front windshield, and the rear trunk lid.

14. The vehicle having photovoltaic cells according to claim 13, wherein the layers in the third photovoltaic cell structure are deposited in the laminated glass by vapor deposition.

15. A method for manufacturing a vehicle having photovoltaic cells, **characterized by** comprising:
arranging first photovoltaic cell structures optionally on corresponding structures of a vehicle window, a front windshield, a sunroof glass, rear windshield, and a rear trunk lid;
arranging second photovoltaic cell structures optionally on corresponding structures of a hood of the vehicle, a vehicle door, a sunroof, the rear trunk lid, and the rear windshield;
arranging third photovoltaic cell structures on corresponding structures of the sunroof and the rear trunk lid;
mounting the front windshield, the sunroof glass, the rear trunk lid, the hood of the vehicle, the vehicle door, the vehicle window, and the rear windshield onto a main body of the vehicle; and
connecting the first photovoltaic cell structures, the second photovoltaic cell structures, and the third photovoltaic cell structures to a vehicle-mounted battery.

16. The method for manufacturing the vehicle having photovoltaic cells according to claim 15, wherein arranging the first photovoltaic cell structures optionally on the corresponding structures of the vehicle window, the front windshield, the sunroof glass, rear windshield, and the rear trunk lid comprises:
placing lower encapsulation layers;
laying first adhesive layers on the lower encapsulation layers;
laying the first photovoltaic cell structures on the first adhesive layers;
laying second adhesive layers on the first photovoltaic cell structures;
placing upper encapsulation layers on the second adhesive layers; and
laminating and encapsulation the lower encapsulation layers, the first adhesive layers, the first photovoltaic cell structures, the second adhesive layers, and the upper encapsulation layers to form the vehicle window, the front windshield, the sunroof glass, the rear windshield, and the rear trunk lid that having the first photovoltaic cell structures.

17. The method for manufacturing the vehicle having photovoltaic cells according to claim 15, wherein arranging the second photovoltaic cell structures optionally on the corresponding structures of the hood of the vehicle, the vehicle door, the sunroof, the rear trunk lid, and the rear windshield comprises:
cleaning surfaces of the second photovoltaic cell structures facing the hood of the vehicle, the vehicle door, the sunroof, the rear trunk lid or the rear windshield;
cleaning the hood of the vehicle, the vehicle door, the sunroof, the rear trunk lid, and the rear windshield;
pre-coating a surfactant on the cleaned surfaces of the hood of the vehicle, the vehicle door, the sunroof, the rear trunk lid, and the rear windshield;
arranging adhesives on the surfaces of the vehicle door, the sunroof, the rear trunk lid, and the rear windshield and
adhering the second photovoltaic cell structures to the vehicle door, the sunroof, the rear trunk lid, and the rear windshield respectively.

18. The method for manufacturing the vehicle having photovoltaic cells according to claim 15, wherein arranging the third photovoltaic cell structure on the corresponding structures of the sunroof and the rear trunk lid comprises:
cleaning a surface of a tempered glass of the sunroof or the rear trunk lid; and
depositing a transparent conductive layer, a photoelectric absorption and conversion layer, another transparent conductive layer, a metal finger electrode layer, and an insulating passivation layer sequentially on the tempered glass.
